# FASCICULE DE BREVET EUROPEEN

(11) **EP 2 011 235 B1**
(45) Date de publication et mention de la délivrance du brevet: **03.07.2013**
(21) Numéro de dépôt: 07728218.4
(22) Date de dépôt: 18.04.2007
(51) Int. Cl.: H03K 17/082, H02H 9/00

(54) **DISPOSITIF DE SECURITE POUR INTERRUPTEUR A SEMI-CONDUCTEURS**
SICHERHEITSEINRICHTUNG FÜR EINEN HALBLEITERSCHALTER
SAFETY DEVICE FOR A SEMICONDUCTOR SWITCH

(30) Priorité: 21.04.2006 FR 0651413
(43) Date de publication de la demande: 07.01.2009
(73) Titulaire: AIRBUS OPERATIONS (S.A.S), 31060 Toulouse (FR)
(72) Inventeur: ROUSSET, David, 31300 Toulouse (FR)
(74) Mandataire: Schmit, Christian Norbert Marie
(86) Numéro de dépôt international: PCT/EP2007/053756
(87) Numéro de publication internationale: WO 2007/122150

(56) Documents cités:
- EP-A- 1 583 193
- WO-A-02/095895
- DE-A1- 4 000 674
- DE-C1- 3 622 268
- US-A- 3 878 434

## Description

La présente invention concerne un dispositif de sécurité pour interrupteurs à semi-conducteurs notamment utilisés pour ouvrir ou fermer des lignes secondaires, reliées à un réseau primaire et permettant d'alimenter des équipements secondaires.

Les interrupteurs à semi-conducteurs comportent une protection en courant permettant d'ouvrir les circuits secondaires et de protéger les câbles du réseau secondaire en cas de sur-intensité dans les circuits secondaires.

La protection en courant est calibrée pour ouvrir l'interrupteur à partir d'une valeur déterminée d'énergie i2.t calculée, inférieure à la courbe de fumée caractérisant les câbles utilisés notamment dans les câblages avioniques.

Ces interrupteurs à semi-conducteurs sont généralement pourvus d'un circuit de protection en courant, comportant des moyens de détection du courant traversant la ligne secondaire qui mesurent la différence de potentiel aux bornes d'une résistance série insérée dans le circuit secondaire, et, comportant un circuit, de commande du composant interrupteur, mesurant la valeur du courant dans la ligne du circuit secondaire et activant le composant interrupteur en circuit ouvert en en cas de sur-intensité dépassant un seuil de courant défini dans la ligne secondaire.

L'interrupteur à semi-conducteurs est donc pourvu d'une commande d'ouverture fermeture pilotée en fonctionnement normal par un système externe et d'une commande d'ouverture issue du circuit de protection en courant.

Un problème rencontré avec ces interrupteurs est que leur mode de défaillance est généralement le passage en court-circuit du composant interrupteur constitué généralement d'un transistor MOS de puissance.

Lors d'une telle défaillance, il n'est plus possible de commander l'ouverture de la ligne secondaire ce qui supprime la protection contre les sur-intensité et peut conduire à un chauffage destructeur des câbles secondaires en cas de problème sur l'équipement voir même conduire à endommager la ligne primaire.

Une solution connue est de disposer un fusible en amont de l'interrupteur à semi-conducteurs, ce fusible étant calibré pour se rompre lorsqu'une valeur seuil de niveau supérieur à la valeur de coupure de sécurité de l'interrupteur est atteinte.

Il reste que dans l'art antérieur, la coupure de ce fusible n'intervient qu'en cas de défaillance du circuit aval et, du fait de la dispersion des caractéristiques des fusibles, sauf à dimensionner le fusible à une valeur de rupture très inférieure à la capacité de courant du câble, on ne peut pas aisément garantir l'ouverture du circuit à un niveau d'intensité non préjudiciable aux câbles lorsque l'interrupteur est en court-circuit.

Les câbles doivent donc être surdimensionnés tant par rapport à la valeur de coupure du fusible que par rapport au courant de coupure du dispositif interrupteur et le dispositif interrupteur doit être lui aussi surdimensionné par rapport au courant nominal de la ligne secondaire pour réduire le risque de destruction du transistor de puissance.

*"Le document* WO 02/095895 A *décrit un dispositif de sécurité destiné à protéger un équipement connecté de manière permanente à une ligne électrique et à éviter une surchauffe de cet équipement ou d'une résistance de limitation de courant sur la ligne par la mise en place de résistances et d'un fusible sur la ligne électrique ainsi que d'un circuit fonctionnant à la manière d'un régulateur en parallèle à la résistance de limitation de courant."*

La présente invention concerne un perfectionnement des interrupteurs à semi-conducteurs qui a pour but la réalisation d'un dispositif de sécurité assurant la coupure d'un fusible et la protection d'un câblage en amont et en aval d'un interrupteur à semi-conducteurs en cas de défaillance de cet interrupteur.

Pour ce faire la présente invention prévoit un dispositif de sécurité, pour dispositif interrupteur semi-conducteur commandant une ligne secondaire munie d'un fusible en amont du dispositif interrupteur, qui comporte un composant de mise en court circuit de la ligne secondaire, en sorte de couper le fusible, et des moyens d'activation de ce composant sur détection d'une sur-intensité dans la ligne secondaire.

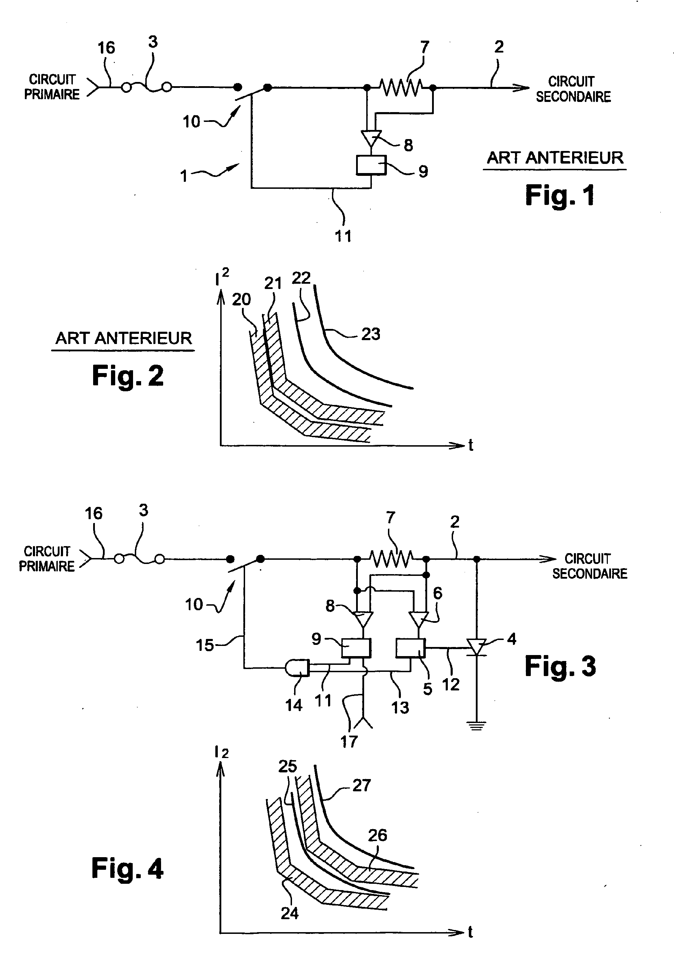

D'autres caractéristiques et avantages de l'invention ressortiront à la lecture de la description d'un exemple de réalisation non limitatif de l'invention en référence aux dessins qui représentent:
en figure 1 : un schéma d'un dispositif interrupteur de l'art antérieur,
en figure 2: des courbes de caractéristiques temps/énergie électrique correspondant au schéma de la figure 1,
en figure 3: un schéma d'un dispositif interrupteur équipé du dispositif de sécurité selon l'invention,
en figure 4: les courbes de caractéristiques temps/énergie électrique correspondant au schéma de la figure 3.

La figure 1 représente un dispositif interrupteur utilisé pour commander une ligne ou circuit secondaire 2, comportant des équipements tels que des équipements avioniques connus non représentés, à partir d'une ligne ou circuit primaire 16.

De manière connue, plusieurs circuits secondaires peuvent être raccordés en parallèle sur le circuit primaire et les courants consommés par ces circuits secondaires sont cumulés au niveau du circuit primaire 16 ce qui conduit à accroître la section des câbles du circuit primaire.

Le dispositif interrupteur 1 est préférentiellement un commutateur de puissance à semi-conducteurs, sous forme de circuit monolithique ou hybride, comportant une protection en courant qui sert notamment à protéger le câble d'un circuit secondaire contre une surchauffe due à un courant trop important dans la ligne secondaire.

Le dispositif interrupteur comprend un composant interrupteur 10, commandé par un dispositif de commande comportant une voie de commande 17 venant par exemple d'un organe de commande non représenté d'une machine ou, dans le cas d'une application aéronautique, d'un tableau de commande du poste de pilotage d'un aéronef.

Le dispositif interrupteur comprend un composant interrupteur 10 qui peut être un commutateur analogique à transistors MOS ou éventuellement un relais et un premier amplificateur et/ou comparateur de tension 8 dont les entrées sont raccordées aux bornes d'une résistance de contrôle 7 permettant de générer une différence de potentiel proportionnelle au courant traversant la ligne secondaire 2.

Ce dispositif comprend avantageusement un premier microcontrôleur 9 de commande du composant interrupteur 10, recevant un signal amplifié du premier amplificateur et/ou comparateur de tension, et, programmé pour commuter le composant interrupteur 10 en circuit fermé ou ouvert selon la valeur du signal

amplifié, le premier microcontrôleur comportant une sortie 11 de commande du composant interrupteur 10.

Dans le cadre de l'invention le premier microcontrôleur peut être remplacé par un circuit en logique câblée, les seuils et niveau de commande étant alors fixés par des valeurs de résistances, le comparateur donnant un signal de sortie logique.

Lorsque le seuil de coupure du circuit secondaire est atteint sur une surintensité par exemple, le dispositif interrupteur coupe le circuit secondaire en faisant passer le composant interrupteur de l'état passant à l'état ouvert pour isoler le circuit secondaire.

Par contre si le seuil est dépassé sans que le dispositif interrupteur ne coupe le circuit, par exemple en cas de défaillance du composant interrupteur bloqué en circuit fermé, un fusible 3 est prévu de sorte que si le courant augmente au delà du courant maximal accepté par le fusible 3, ce dernier se coupe et isole la ligne secondaire en second niveau de sécurité.

Outre le dispositif interrupteur 1, le circuit de commande de la ligne secondaire 2 comporte donc le fusible 3 dont le seuil de rupture est calculé en sorte d'être au dessus du seuil de déclenchement de la protection du dispositif interrupteur et d'être au dessous du seuil de surchauffe du câble secondaire lui même au dessous du seuil de surchauffe du câble primaire.

Les courbes de la figure 2, pour laquelle l'abscisse représente le temps et l'ordonnée représente le carré du courant traversant le composant interrupteur et la ligne secondaire, correspondent à l'illustration de ces niveaux, le repère 20 correspondant à la zone d'ouverture du dispositif interrupteur, le repère 21 à la zone de rupture du fusible, le repère 22 à la caractéristique i2.t du câble de la ligne secondaire 2 et le repère 23 la caractéristique i2.t du câble de la ligne principale 16.

La rupture du fusible doit se faire entre la valeur de seuil d'ouverture de l'interrupteur et au dessous de tout risque de détérioration du câble secondaire.

Du fait de la dispersion des valeurs de courant des fusibles et, afin d'éviter tout risque de recouvrement de la zone de rupture du fusible et de la zone d'ouverture du dispositif interrupteur qui pourrait engendrer une rupture du fusible avant l'ouverture de l'interrupteur, on est obligé de baisser le niveau de détection

de l'interrupteur ce qui a pour conséquence d'utiliser un dispositif interrupteur surdimensionné avec une ligne supportant un courant plus faible et de sur dimensionner les systèmes associés et éventuellement les câbles.

Un exemple de réalisation du dispositif de sécurité selon l'invention est donné en figure 3.

Ce dispositif de sécurité, pour dispositif interrupteur semi-conducteur 10 commandant une ligne secondaire 2 munie d'un fusible 3 en amont du dispositif interrupteur, comporte un composant 4 de mise en court circuit de la ligne secondaire commandée par le dispositif interrupteur.

Ce composant de mise en court-circuit est disposé entre la ligne secondaire 2 et une masse en sorte de couper le fusible 3 en générant une sur-intensité en courant dans la ligne secondaire et au niveau du fusible 3 sur détection d'une anomalie.

En fonctionnement normal, ce composant est ouvert.

Le dispositif de sécurité comporte des moyens 5, 6, 7 d'activation du composant 4 de mise en court-circuit sur détection d'une sur-intensité en courant dans la ligne secondaire.

Ainsi, lorsqu'une sur-intensité est détectée le composant 4 est mis en court-circuit et accroît encore le courant pour forcer et/ou accélérer la rupture du fusible.

Selon la figure 3, les moyens d'activation du composant 4 comprennent des moyens 7 de détection d'une différence de potentiel aux bornes du dispositif interrupteur, des moyens 6 de comparaison de cette différence de potentiel à un seuil et des moyens 5 de commande du composant interrupteur 4 sur détection d'un dépassement du seuil.

Avantageusement, les moyens de détection sont une résistance 7 placée en série dans le circuit secondaire qui va créer une différence de potentiel à ses bornes en fonction du courant traversant la ligne secondaire 2 et commander le dispositif interrupteur.

Pour éviter de cumuler des résistances dans le circuit secondaire, la résistance est préférentiellement la résistance de contrôle du dispositif interrupteur déjà utilisée pour mesurer le courant traversant la ligne secondaire.

Le circuit de mise en court circuit comprend en outre un second amplificateur et/ou comparateur de tension 6 dont les entrées sont reliées aux bornes de la résistance de contrôle 7 et, dans le cas où l'on choisit une solution de type intelligente, un second microcontrôleur 5 de commande du composant 4 de mise en court-circuit de la ligne.

Le second microcontrôleur reçoit un signal amplifié du second amplificateur et/ou comparateur de tension et est programmé pour activer le composant 4 de mise en court-circuit de la ligne, selon la valeur du signal amplifié au delà d'une valeur de seuil prédéfinie, au travers d'une sortie 12 de commande du composant 4 de mise en court-circuit de la ligne.

Le second microcontrôleur peut, dans le cadre de l'invention tout comme le premier microcontrôleur, être remplacé par de la logique câblée.

Le dispositif de sécurité est calibré pour mettre la ligne en court-circuit sur occurrence d'une surintensité en courant de niveau supérieur à un niveau de courant d'activation de l'ouverture du circuit secondaire par le circuit de protection en courant de l'interrupteur 1.

Ainsi, le dispositif de sécurité ne sera activé qu'en cas de défaillance en court-circuit du composant interrupteur 10 qui n'aura dans ce cas pas pu couper la ligne secondaire au niveau de courant nominal de sécurité de l'interrupteur.

Pour éviter tout recouvrement entre les deux systèmes, dispositif interrupteur et dispositif de sécurité, le second microcontrôleur 5 comporte selon l'exemple une sortie complémentaire 13 de commande du composant interrupteur 10 et le dispositif comporte une porte logique OU 14, intercalée entre la sortie de commande 11 du premier microcontrôleur et une entrée de commande 15 du composant interrupteur 10, et recevant les signaux de la sortie complémentaire 13, pour déclencher l'ouverture du composant interrupteur sur le passage à 1 de la sortie de commande 11 ou de la sortie complémentaire 13.

Selon l'invention, le composant 4 de mise en court circuit est préférablement un commutateur semi-conducteur, soit un thyristor lorsque le circuit secondaire est alimenté en continu, la différence de potentiel aux bornes du dispositif interrupteur étant une différence de potentiel continue, soit un triac dans le cas d'une ligne alimentée en courant alternatif, la différence de potentiel aux bornes du dispositif interrupteur étant alors une différence de potentiel alternative.

Les courbes énergie/temps des divers composants d'un circuit selon l'invention sont représentées à la figure 4.

L'abscisse représente ici aussi le temps et l'ordonnée le carré du courant traversant le composant interrupteur et la ligne secondaire.

Le repère 24 correspond à la zone d'ouverture du dispositif interrupteur et de fermeture du composant de mise en court-circuit, le repère 25 correspond à la caractéristique i².t du câble de la ligne secondaire 2, le repère 26 correspond à la zone de rupture du fusible et le repère 27 correspond à la caractéristique i².t du câble de la ligne principale 16.

La courbe i².t d'activation en court circuit du dispositif de sécurité selon l'invention est avantageusement définie au dessous de la courbe de fumée du câble secondaire et au dessous de la courbe i².t de rupture du fusible, la courbe de rupture du fusible pouvant ainsi se trouver au delà de la courbe de fumée du câble secondaire sans risque.

En effet, comme le fonctionnement du dispositif de sécurité, utilisant un thyristor ou un triac, est plus déterministe que la courbe de rupture d'un fusible, les dispositifs interrupteurs utilisés peuvent avoir une courbe i².t plus élevée, cette courbe se rapprochant de celle du câble secondaire.

La zone d'ouverture du fusible peut alors être remontée au dessus de la caractéristique du câble secondaire puisque la rupture du fusible, suite à la génération du court-circuit par le composant 4, est suffisamment rapide pour éviter un échauffement préjudiciable du câble du circuit secondaire.

Le dispositif selon l'invention permet ainsi d'utiliser des commutateur de puissance à semi-conducteurs sur des systèmes fonctionnant avec des courants plus importants qu'en son absence et évite de sur-dimensionner les composants de puissance de tels commutateurs.

Dans le cadre de l'invention, un seul micro-contrôleur et un seul amplificateur et/ou comparateur de tension peuvent être utilisés et mis en commun pour le dispositif interrupteur et le dispositif de sécurité mais on privilégiera une solution redondante telle que décrite pour éviter tout problème sur apparition d'une panne simple.

L'utilisation d'une seule résistance reste toutefois préférée pour éviter d'accroître les pertes sur la ligne et du fait que la défaillance d'un tel composant conduit à un circuit ouvert plutôt qu'à un court-circuit.

## Revendications

1. Dispositif de sécurité pour interrupteur à semi-conducteur (10) adapté à assurer la coupure d'un fusible en amont dudit Interrupteur à semi conducteur et la protection d'un câblage en aval dudit interrupteur à semi-conducteurs en cas de défalliance dudit interrupteur, **caractérisé en ce qu'**il comporte un composant (4) de mise en court circuit de la ligne secondaire disposé en aval du fusible en sorte de couper le fusible (3), et des moyens (5, 6, 7) d'activation de ce composant (4) sur détection d'une surintensité en courant dans la ligne secondaire, les moyens d'activation comprenant des moyens de détection de ladite surintensité.

2. Dispositif de sécurité pour interrupteur à semi-conducteur (10) selon la revendication 1 pour lequel les moyens de détection de ladite surintensité en courant comprennent des moyens (7) de détection d'une différence de potentiel aux bornes du dispositif interrupteur, des moyens (6) de comparaison de cette différence de potentiel à un seuil et des moyens (5) de commande du composant de mise en court circuit (4) sur détection d'un dépassement du seuil.

3. Dispositif de sécurité pour interrupteur à semi-conducteur (10) selon la revendication 2 pour lequel les moyens de détection d'une différence de potentiel sont une résistance (7) de contrôle du dispositif interrupteur.

4. Dispositif de sécurité pour interrupteur à semi-conducteur (10) selon la revendication 3 pour lequel, le dispositif interrupteur comprenant un premier amplificateur et/ou comparateur de tension (8) aux bornes de la résistance de contrôle (7), un premier microcontrôleur (9) de commande d'un composant Interrupteur (10), recevant un signal amplifié du premier amplificateur et/ou comparateur de tension et programmé pour commuter le composant Interrupteur (10) selon la valeur du signal amplifié et comportant une sortie (11) de commande du composant interrupteur (10), le circuit de mise en court circuit comprend un second amplificateur et/ou comparateur de tension (6), aux bornes de la résistance de contrôle (7), un second microcontrôleur (5) de commande d'un composant (4) de mise en court-circuit de la ligne, recevant un signal amplifié du premier amplificateur et/ou comparateur de tension et programmé pour activer le composant (4) de mise en court-circuit de la ligne selon la valeur du signal amplifié, le second microcontrôleur comportant une sortie (11) de commande du composant (4) de mise en court-circuit de la ligne.

5. Dispositif de sécurité pour interrupteur à semi-conducteur (10) selon la revendication 4 pour lequel le second microcontrôleur (5) comporte une sortie complémentaire (13) de commande du composant interrupteur (10) et pour lequel le dispositif comporte une porte logique OU (14) intercalée entre la sortie de commande (11) du premier microcontrôleur et une entrée de commande (15) du composant interrupteur (10) et recevant les signaux de la sortie complémentaire (13) pour déclencher l'ouverture du composant interrupteur sur le passage à 1 de la sortie de commande (11) ou de la sortie complémentaire (13).

6. Dispositif de sécurité pour interrupteur à semi-conducteur (10) selon l'une des revendications précédentes pour lequel le composant (4) de mise en court circuit est un commutateur semi-conducteur.

7. Dispositif de sécurité pour interrupteur à semi-conducteur (10) selon la revendication 6 pour lequel le commutateur est un thyristor, la différence de potentiel aux bornes du dispositif interrupteur étant une différence de potentiel continue.

8. Dispositif de sécurité pour interrupteur à semi-conducteur (10) selon la revendication 6 pour lequel le commutateur est un triac, la différence de potentiel aux bornes du dispositif interrupteur étant une différence de potentiel alternative.

9. Dispositif de sécurité pour interrupteur à semi-conducteur (10) selon l'une des revendications précédentes **caractérisé en ce qu'**il est calibré pour mettre la ligne en court-circuit sur occurrence d'une surintensité en courant de niveau supérieur à un niveau de courant d'activation de l'ouverture du circuit secondaire par ledit interrupteur.

10. Dispositif de sécurité pour interrupteur à semi-conducteur (10) selon l'une des revendications précédentes **caractérisé en ce que** la courbe i2.t d'activation en court circuit du dispositif de sécurité est définie au dessous de la courbe de fumée du câble secondaire et au dessous de la courbe i2.t de rupture du fusible.

11. Dispositif de commande d'une ligne secondaire (2) comprenant un dispositif interrupteur à semi-conducteur en aval d'un fusible et un dispositif de sécurité selon l'une quelconque des revendications précédentes en aval du dispositif interrupteur à semi-conducteur.

## Patentansprüche

1. Sicherheitsvorrichtung für einen Unterbrecher mit Halbleiter (10), die geeignet ist, um die Abschaltung einer Sicherung vor dem Unterbrecher mit Halbleiter und den Schutz einer Verkabelung hinter dem Unterbrecher mit Halbleitern bei einem Ausfall des Unterbrechers zu gewährleisten, **dadurch gekennzeichnet, dass** sie ein Bauteil (4) zum Kurzschließen der Sekundärleitung, das hinter der Sicherung angeordnet ist, um die Sicherung (3) abzuschalten, und Einrichtungen (5, 6, 7) zur Aktivierung dieses Bauteils (4) bei Erfassung eines Überstroms in der Sekundärleitung aufweist, wobei die Aktivierungseinrichtungen Einrichtungen zur Erfassung des Überstroms enthalten.

2. Sicherheitsvorrichtung für einen Unterbrecher mit Halbleiter (10) nach Anspruch 1, bei der die Erfassungseinrichtungen des Überstroms Einrichtungen (7) zur Erfassung einer Potentialdifferenz an den Klemmen der Unterbrechervorrichtung, Einrichtungen (6) zum Vergleich dieser Potentialdifferenz mit einer Schwelle und Einrichtungen (5) zur Steuerung des Kurzschlussbauteils (4) bei Erfassung einer Überschreitung der Schwelle enthalten.

3. Sicherheitsvorrichtung für einen Unterbrecher mit Halbleiter (10) nach Anspruch 2, bei der die Erfassungseinrichtungen einer Potentialdifferenz ein Kontrollwiderstand (7) der Unterbrechervorrichtung sind.

4. Sicherheitsvorrichtung für einen Unterbrecher mit Halbleiter (10) nach Anspruch 3, bei der, wobei die Unterbrechervorrichtung einen ersten Verstärker und/oder Spannungskomparator (8) an den Klemmen des Kontrollwiderstands (7), einen ersten Mikrocontroller (9) zur Steuerung eines Unterbrecherbauteils (10) enthält, der ein verstärktes Signal vom ersten Verstärker und/oder Spannungskomparator empfängt und programmiert ist, um das Unterbrecherbauteil (10) gemäß dem Wert des verstärkten Signals umzuschalten, und einen Steuerausgang (11) des Unterbrecherbauteils (10) aufweist, die Kurzschlussschaltung einen zweiten Verstärker und/oder Spannungskomparator (6) an den Klemmen des Kontrollwiderstands (7), einen zweiten Mikrocontroller (5) zur Steuerung eines Bauteils (4) zum Kurzschließen der Leitung enthält, der ein verstärktes Signal vom ersten Verstärker und/oder Spannungskomparator empfängt und programmiert ist, um das Bauteil (4) zum Kurzschließen der Leitung gemäß dem Wert des verstärkten Signals zu aktivieren, wobei der zweite Mikrocontroller einen Steuerausgang (12) des Bauteils (4) zum Kurzschließen der Leitung aufweist.

5. Sicherheitsvorrichtung für einen Unterbrecher mit Halbleiter (10) nach Anspruch 4, bei der der zweite Mikrocontroller (5) einen komplementären Steuerausgang (13) des Unterbrecherbauteils (10) aufweist, und bei der die Vorrichtung ein logisches ODER-Glied (14) aufweist, das zwischen den Steuerausgang (11) des ersten Mikrocontrollers und einen Steuereingang (15) des Unterbrecherbauteils (10) eingefügt ist und die Signale vom komplementären Ausgang (13) empfängt, um die Öffnung des Unterbrecherbauteils beim Übergang auf 1 des Steuerausgangs (11) oder des komplementären Ausgangs (13) auszulösen.

6. Sicherheitsvorrichtung für einen Unterbrecher mit Halbleiter (10) nach einem der vorhergehenden Ansprüche, bei der das Kurzschlussbauteil (4) ein Halbleiterschalter ist.

7. Sicherheitsvorrichtung für einen Unterbrecher mit Halbleiter (10) nach Anspruch 6, bei der der Schalter ein Thyristor ist, wobei die Potentialdifferenz an den Klemmen der Unterbrechervorrichtung eine kontinuierliche Potentialdifferenz ist.

8. Sicherheitsvorrichtung für einen Unterbrecher mit Halbleiter (10) nach Anspruch 6, bei der der Schalter ein Triac ist, wobei die Potentialdifferenz an den Klemmen der Unterbrechervorrichtung eine alternative Potentialdifferenz ist.

9. Sicherheitsvorrichtung für einen Unterbrecher mit Halbleiter (10) nach einem der vorhergehenden Ansprüche, **dadurch gekennzeichnet, dass** sie kalibriert ist, um die Leitung bei Auftreten eines Überstroms eines höheren Pegels als ein Aktivierungsstrompegel der Öffnung der Sekundärschaltung durch den Unterbrecher kurzzuschließen.

10. Sicherheitsvorrichtung für einen Unterbrecher mit Halbleiter (10) nach einem der vorhergehenden Ansprüche, **dadurch gekennzeichnet, dass** die Kurzschluss-Aktivierungskurve i2.t der Sicherheitsvorrichtung unter der Rauchkurve des Sekundärkabels und unter der Abschaltkurve i2.t der Sicherung definiert ist.

11. Steuervorrichtung einer Sekundärleitung (2), die eine Unterbrechervorrichtung mit Halbleiter hinter einer Sicherung und eine Sicherheitsvorrichtung nach einem der vorhergehenden Ansprüche hinter der Unterbrechervorrichtung mit Halbleiter aufweist.

## Claims

1. Safety device for a semiconductor breaker switch (10) adapted to ensure the cutting of a fuse upstream of said semiconductor breaker switch and the protection of a wiring downstream of said semiconductor breaker switch in case of failure of said breaker, **characterized in that** it comprises a secondary-line short-circuiting component (4) disposed downstream of the fuse so as to cut the fuse (3), and means (5, 6, 7) for activating this component (4) on detection of a current surge in the secondary line, the activation means comprising means for detecting said surge.

2. Safety device for semiconductor breaker switch (10) according to Claim 1, for which the means for detecting said current surge comprise means (7) for detecting a potential difference across the terminals of the breaker device, means (6) for comparing this potential difference with a threshold and means (5) for driving the short-circuiting component (4) on detection of an exceeding of the threshold.

3. Safety device for semiconductor breaker switch (10) according to Claim 2, for which the means for detecting a potential difference are a control resistor (7) for the breaker device.

4. Safety device for semiconductor breaker switch (10) according to Claim 3, for which, the breaker device comprising a first amplifier and/or comparator of voltage (8) across the terminals of the control resistor (7), a first microcontroller (9) for driving a breaker component (10), receiving an amplified signal from the first amplifier and/or comparator of voltage and programmed to switch the breaker component (10) according to the value of the amplified signal and comprising an output (11) for driving the breaker component (10), the short-circuiting circuit comprises a second amplifier and/or comparator of voltage (6), across the terminals of the control resistor (7), a second microcontroller (5) for driving a component (4) for short-circuiting the line, receiving an amplified signal from the first amplifier and/or comparator of voltage and programmed to activate the component (4) for short-circuiting the line according to the value of the amplified signal, the second microcontroller comprising an output (12) for driving the component (4) for short-circuiting the line.

5. Safety device for semiconductor breaker switch (10) according to Claim 4, for which the second microcontroller (5) comprises a complementary output (13) for driving the breaker component (10) and for which the device comprises an OR logic gate (14) inserted between the drive output (11) of the first microcontroller and a drive input (15) of the breaker component (10) and receiving the signals from the complementary output (13) so as to trigger the opening of the breaker component on the toggling to 1 of the drive output (11) or of the complementary output (13).

6. Safety device for semiconductor breaker switch (10) according to one of the preceding claims, for which the short-circuiting component (4) is a semiconductor switch.

7. Safety device for semiconductor breaker switch (10) according to Claim 6, for which the switch is a thyristor, the potential difference across the terminals of the breaker device being a continuous potential difference.

8. Safety device for semiconductor breaker switch (10) according to Claim 6, for which the switch is a triac, the potential difference across the terminals of the breaker device being an alternating potential difference.

9. Safety device for semiconductor breaker switch (10) according to one of the preceding claims, **characterized in that** it is calibrated so as to short-circuit the line on occurrence of a current surge of greater level than a level of current for activating the opening of the secondary circuit by the said breaker.

10. Safety device for semiconductor breaker switch (10) according to one of the preceding claims, **characterized in that** the short-circuit activation i².t curve of the safety device is defined below the smoke curve of the secondary wire and below the i².t rupture curve of the fuse.

11. Device for driving a secondary line (2) comprising a semiconductor breaker switch device downstream of a fuse and a safety device according to any one of the preceding claims downstream of the semiconductor breaker switch device.
